# EUROPEAN PATENT APPLICATION

(11) **EP 4 783 055 A1**
(43) Date of publication of application: **29.07.2026**
(21) Application number: 24868319.5
(22) Date of filing: 19.09.2024
(51) Int. Cl.: G06F 30/10

(54) **TWO-DIMENSIONAL MODEL GENERATION METHOD, TWO-DIMENSIONAL MODEL GENERATION DEVICE, AND PROGRAM**

(30) Priority: 20.09.2023 JP 2023152322
(71) Applicant: Resonac Corporation, Tokyo 105-7325 (JP)
(72) Inventor: SEKINE, Chisa, Tokyo 105-7325 (JP); NISHINO, Takayuki, Tokyo 105-7325 (JP); OKUNO, Yoshishige, Tokyo 105-7325 (JP); HASEGAWA, Takahiko, Tokyo 105-7325 (JP); KAWANAMI, Kenichi, Tokyo 105-7325 (JP); KONDO, Kunio, Tokyo 105-7325 (JP)
(74) Representative: Strehl & Partner mbB
(86) International application number: PCT/JP2024/033477
(87) International publication number: WO 2025/063242

(57) **Abstract**

Two-dimensional model generation method for generating two-dimensional model of taper screw-connected structure is provided. Two-dimensional model generation method for generating two-dimensional model of connected structure in which first column member including first taper nut part and second column member including second taper nut part are connected by joint member including main part and first and second taper bolt parts, is performed by a computer, and includes receiving input parameters; depicting vertically symmetrical main part, vertically symmetrical first and second taper bolt parts, and vertically symmetrical first and second taper nut parts based on input parameters; displacing first taper bolt part, and first and second taper nut parts horizontally radially outward based on input parameters; displacing joint member main part vertically based on input parameters; displacing second taper bolt part horizontally radially inward based on input parameters; and displacing second taper nut part along taper based on input parameters.

## Description

### TECHNICAL FIELD

The present invention relates to a two-dimensional model generation method, a two-dimensional model generation device, and a program.

### BACKGROUND ART

PTL 1 discloses a graphite electrode including: a pole having a nut-like socket at an end; and a bolt-like nipple that can be fastened to the socket.

### CITATION LIST

### PATENT LITERATURE

PTL 1: Japanese Patent Application Laid-Open Publication No. 2022-142242

### SUMMARY OF THE INVENTION

### TECHNICAL PROBLEM

The present invention provides a two-dimensional model generation method, a two-dimensional model generation device, and a program for generating a two-dimensional model of a taper screw-connected structure.

### SOLUTION TO THE PROBLEM

To achieve the above object, one embodiment provides a two-dimensional model generation method for generating a two-dimensional model of a connected structure in which a first column member including a first taper nut part and a second column member including a second taper nut part are connected by a joint member including a main part, a first taper bolt part, and a second taper bolt part, the two-dimensional model generation method including causing a computer to perform:
receiving parameters that are input;
depicting the main part that is vertically symmetrical, the first taper bolt part and the second taper bolt part that are vertically symmetrical to each other, and the first taper nut part and the second taper nut part that are vertically symmetrical to each other based on the input parameters;
displacing the first taper bolt part, the first taper nut part, and the second taper nut part in a radially outward horizontal direction based on the input parameters;
displacing the main part of the joint member in a vertical direction based on the input parameters;
displacing the second taper bolt part in a radially inward horizontal direction based on the input parameters; and
displacing the second taper nut part along a taper based on the input parameters.

### ADVANTAGEOUS EFFECTS OF THE INVENTION

According to the present invention, it is possible to provide a two-dimensional model generation method, a two-dimensional model generation device, and a program for generating a two-dimensional model of a taper screw-connected structure.

### BRIEF DESCRIPTION OF THE DRAWINGS

[FIG. 1] FIG. 1 is a hardware configuration diagram of a two-dimensional model generation device;
[FIG. 2] FIG. 2 is a side view of an assembled electrode;
[FIG. 3] FIG. 3 is a side view of a disassembled electrode;
[FIG. 4] FIG. 4 is an example of a schematic cross-sectional view illustrating a state in which a first column member, a first joint member, and a second column member are fitted together;
[FIG. 5] FIG. 5 is a diagram illustrating the dimensions of taper screws;
[FIG. 6] FIG. 6 is a flowchart illustrating a two-dimensional model generation method;
[FIG. 7] FIG. 7 is an example of a parameter interface.
[FIG. 8] FIG. 8 is an example of an interface displaying a set mathematical expression.
[FIG. 9] FIG. 9 is an example of a parameter interface with values input.
[FIG. 10] FIG. 10 is an example of the right half of a bisymmetrical two-dimensional axisymmetrical model generated in step S104.
[FIG. 11] FIG. 11 is an example of a two-dimensional model generated in step S105.
[FIG. 12] FIG. 12 is an example of a two-dimensional model generated in step S106.
[FIG. 13] FIG. 13 is an example of a two-dimensional model generated in step S107.
[FIG. 14] FIG. 14 is an example of a two-dimensional model generated in step S108.
[FIG. 15] FIG. 15 is an example of a partially enlarged view of a second taper bolt part geometry and a second taper nut part geometry of the two-dimensional model generated in step S108.

### DETAILED DESCRIPTION OF THE INVENTION

Hereinafter, various exemplary embodiments will be described in detail with reference to the drawings. In the drawings, the same or corresponding parts are assigned the same reference numerals.

### <Two-Dimensional Model Generation Device>

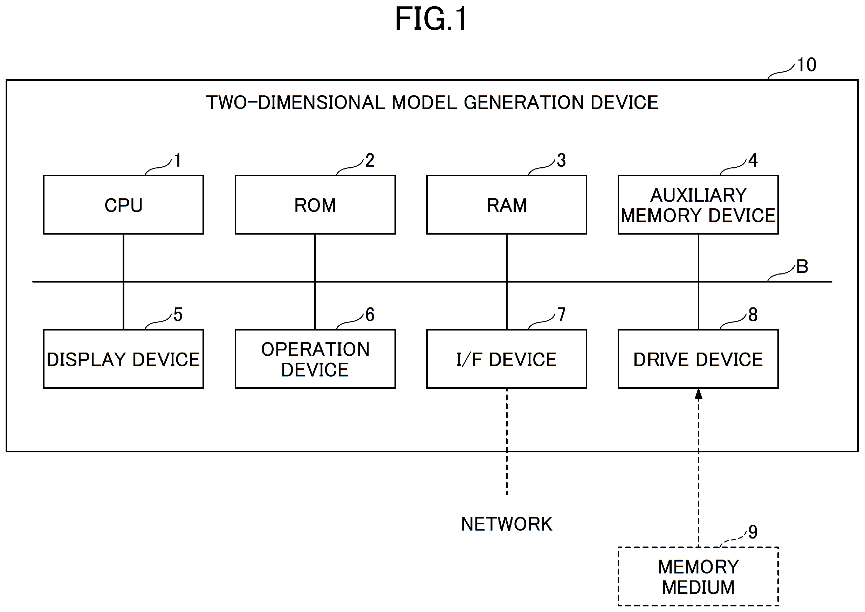

First, an example of the configuration of a two-dimensional model generation device 10 will be described with reference to FIG. 1. FIG. 1 is a hardware configuration diagram of the two-dimensional model generation device 10. The two-dimensional model generation device 10 includes a Central Processing Unit (CPU) 1, a Read Only Memory (ROM) 2, and a Random Access Memory (RAM) 3. The CPU 1, the ROM 2, and the RAM 3 constitute what is generally referred to as a computer. The two-dimensional model generation device 10 may include an auxiliary memory device 4, a display device 5, an operation device 6, an interface (I/F) device 7, and a drive device 8. The hardware components of the two-dimensional model generation device 10 are connected to each other via a bus B.

The CPU 1 (controller) is an arithmetic device for executing various programs installed in the auxiliary memory device 4.

The ROM 2 is a nonvolatile memory. The ROM 2 functions as a main memory device for storing various programs and data required for the CPU 1 to execute various programs installed in the auxiliary memory device 4. Specifically, the ROM 2 functions as a main memory device for storing a boot program and the like. Examples of the boot program include a Basic Input/Output System (BIOS), an Extensible Firmware Interface (EFI), and the like.

The RAM 3 is a volatile memory, such as a Dynamic Random Access Memory (DRAM), a Static Random Access Memory (SRAM), and the like. The RAM 3 functions as a main memory device for providing a work area that is developed when the CPU 1 executes various programs installed in the auxiliary memory device 4.

The auxiliary memory device 4 is an auxiliary memory device for storing various programs and information used when the various programs are executed.

The display device 5 is a display device for displaying the internal state of the two-dimensional model generation device 10 and the like.

The operation device 6 is an input device via which the operator of the two-dimensional model generation device 10 inputs various instructions into the two-dimensional model generation device 10.

The I/F device 7 is a communication device for connecting to a network and communicating with other devices.

The drive device 8 is a device in which a memory medium 9 is set. Here, examples of the memory medium 9 include media for optically, electrically or magnetically recording information, such as a CD-ROM, a flexible disk, a magneto-optical disk, and the like. Further, examples of the memory medium 9 may include a semiconductor memory for electrically recording information, such as an Erasable Programmable Read Only Memory (EPROM), a flash memory, and the like.

The various programs to be installed in the auxiliary memory device 4 are installed by, for example, a distributed memory medium 9 being set in the drive device 8 and the various programs recorded in the memory medium 9 being read out by the drive device 8. Alternatively, the various programs to be installed in the auxiliary memory device 4 may be installed by being downloaded from a network via the I/F device 7.

The two-dimensional model generation device 10 functions as a Computer-Aided Design (CAD) device by executing a program. Thus, when the operator inputs various types of information into the two-dimensional model generation device 10 via the operation device 6 or the like, the two-dimensional model generation device 10 depicts and generates a two-dimensional model (2DCAD data) having a plurality of geometries based on the input information.

### <Electrode>

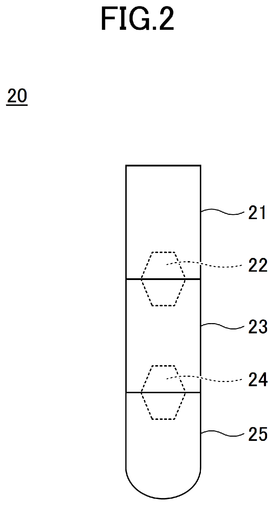

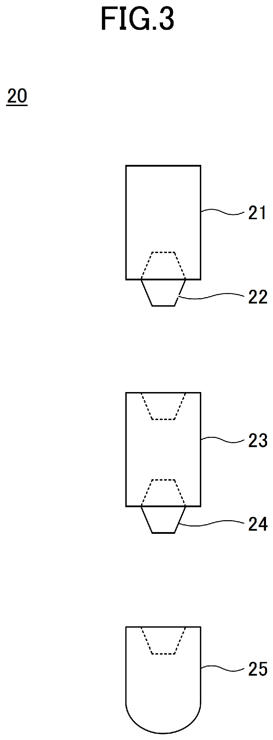

Next, the structure of an electrode 20, of which a two-dimensional model is generated by the two-dimensional model generation device (CAD device) 10 will be described with reference to FIGS. 2 to 5. FIG. 2 is a side view of the electrode 20 in an assembled state. FIG. 3 is a side view of the electrode 20 in a disassembled state.

The electrode 20 shown in FIG. 2 is a graphite electrode used for melting iron scraps in, for example, an electric steelmaking furnace.

As shown in FIGS. 2 and 3, the electrode 20 includes a first column member 21, a first joint member 22, a second column member 23, a second joint member 24, and a third column member 25. That is, the electrode 20 has a connected structure in which the plurality of column members (21, 23, and 25) are connected by the joint members (22 and 24). A structure in which the three column members (21, 23, and 25) are connected will be described as an example of the electrode 20, which, however, is not limited to this structure and may have a structure in which two column members or four or more column members are connected.

The first column member 21, the second column member 23, and the third column member 25 are members having a circular-columnar shape, and are composed of a solid composition containing graphite as a main component.

A truncated-conical recess is formed in an end surface (in FIGS. 2 and 3, the lower surface) of the first column member 21. A first taper nut is formed on the inner circumferential side surface of this recess. The first taper nut is threadedly engageable with one taper bolt of the first joint member 22 (i.e., a taper bolt formed on the upper truncated-conical side surface).

A truncated-conical recess is formed in one end surface (in FIGS. 2 and 3, the upper surface) of the second column member 23. A second taper nut is formed on the inner circumferential side surface of this recess. The second taper nut is threadedly engageable with the other taper bolt of the first joint member 22 (i.e., a taper bolt formed on the lower truncated-conical side surface).

Similarly, a truncated-conical recess is formed in the other end surface (in FIGS. 2 and 3, the lower surface) of the second column member 23. A third taper nut is formed on the inner circumferential side surface of this recess. The third taper nut is threadedly engageable with one taper bolt of the second joint member 24 (i.e., a taper bolt formed on the upper truncated-conical side surface).

A truncated-conical recess is formed in an end surface (in FIGS. 2 and 3, the upper surface) of the third column member 25. A fourth taper nut is formed on the inner circumferential side surface of this recess. The fourth taper nut is threadedly engageable with the other taper bolt of the second joint member 24 (i.e., a taper bolt formed on the lower truncated-conical side surface).

The first joint member 22 and the second joint member 24 are members having a shape obtained by joining two truncated cones by their bottom surfaces (the bottom surfaces having the larger radii), and are composed of a solid composition containing graphite as a main component.

One taper bolt (first taper bolt) threadedly engageable with the first taper nut of the first column member 21 is formed on one truncated-conical side surface of the first joint member 22. The other taper bolt (second taper bolt) threadedly engageable with the second taper nut of the second column member 23 is formed on the other truncated-conical side surface of the first joint member 22.

The one taper bolt (first taper bolt) of the first joint member 22 and the other taper bolt (second taper bolt) of the first joint member 22 are formed with the same taper bolt dimensions. The first taper nut of the first column member 21 and the second taper nut of the second column member 23 are formed with the same taper nut dimensions.

Similarly, one taper bolt (third taper bolt) threadedly engageable with the third taper nut of the second column member 23 is formed on one truncated-conical side surface of the second joint member 24. The other taper bolt (fourth taper bolt) threadedly engageable with the fourth taper nut of the third column member 25 is formed on the other truncated-conical side surface of the second joint member 24.

The one taper bolt (third taper bolt) of the second joint member 24 and the other taper bolt (fourth taper bolt) of the second joint member 24 are formed with the same taper bolt dimensions. The third taper nut of the second column member 23 and the fourth taper nut of the third column member 25 are formed with the same taper nut dimensions.

At the time of shipment of the electrode 20, as shown in FIG. 3, the electrode 20 is shipped in a state in which the first column member 21, the second column member 23, and the third column member 25 are disassembled.

Here, at the time of shipment of the electrode 20, the one taper bolt (first taper bolt) of the first joint member 22 is tightly fastened to the first taper nut of the first column member 21. That is, the electrode 20 is shipped in a state in which the first joint member 22 is attached to the first column member 21.

Similarly, at the time of shipment of the electrode 20, the one taper bolt (third taper bolt) of the second joint member 24 is tightly fastened to the third taper nut of the second column member 23. That is, the electrode 20 is shipped in a state in which the second joint member 24 is attached to the second column member 23.

When using the electrode 20 in an electric steelmaking furnace, as shown in FIG. 2, the first column member 21, the second column member 23, and the third column member 25 of the electrode 20 are connected with each other. That is, the first column member 21 and the second column member 23 are connected by threadedly engaging the other taper bolt (second taper bolt) of the first joint member 22 and the second taper nut of the second column member 23 with each other. The second column member 23 and the third column member 25 are connected by threadedly engaging the other taper bolt (fourth taper bolt) of the second joint member 24 and the fourth taper nut of the third column member 25 with each other.

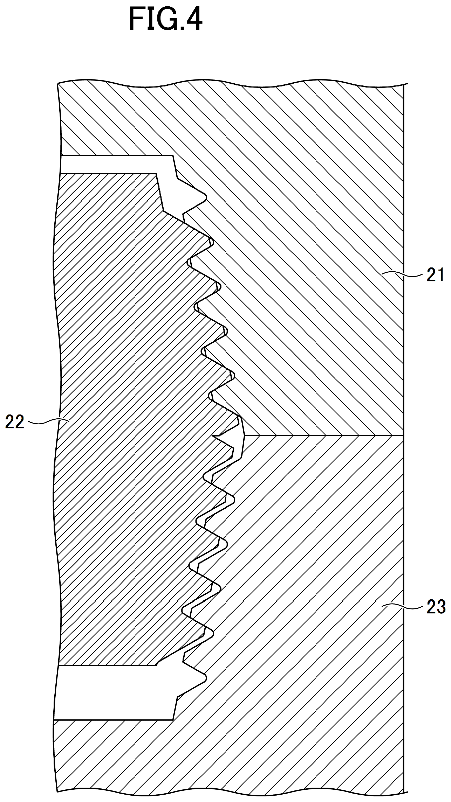

FIG. 4 is an example of a schematic cross-sectional view for explaining a state in which the first column member 21, the first joint member 22, and the second column member 23 are fitted together.

When the electrode 20 is assembled (see FIG. 2), as shown in FIG. 4, the first taper nut of the first column member 21 and the one taper bolt of the first joint member 22 are in contact with each other by both surfaces of each thread. On the other hand, the second taper nut of the second column member 23 and the other taper bolt of the first joint member 22 are in contact with each other only by one surface of each thread.

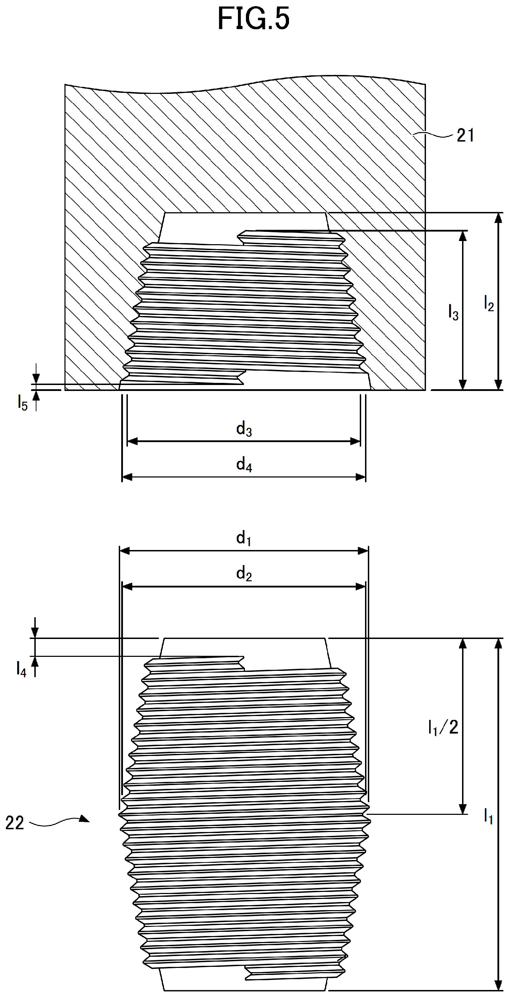

Next, various dimensions of taper screws will be described with reference to FIG. 5. FIG. 5 is a diagram for explaining various dimensions of taper screws.

"l₁" indicates the length of the first joint member 22. The length of the one taper bolt (first taper bolt) of the first joint member 22 is "l₁/2". "l₂" indicates the length of the taper nut of the first column member 21. "l₃" indicates the effective length of the taper nut. "l₄" indicates the undercut length of the taper bolt. "l₅" indicates the undercut length of the taper nut.

"d₁" indicates the major diameter of the taper bolt. "d₂" indicates the effective diameter of the taper bolt (i.e., a diameter obtained by subtracting the height of a thread at the major diameter from the major diameter). "d₃" indicates the inner diameter of the taper nut. "d₄" indicates the effective diameter of the taper nut (i.e., a diameter obtained by subtracting the height of a thread at the major diameter from the major diameter).

### <Two-Dimensional Model Generation Method>

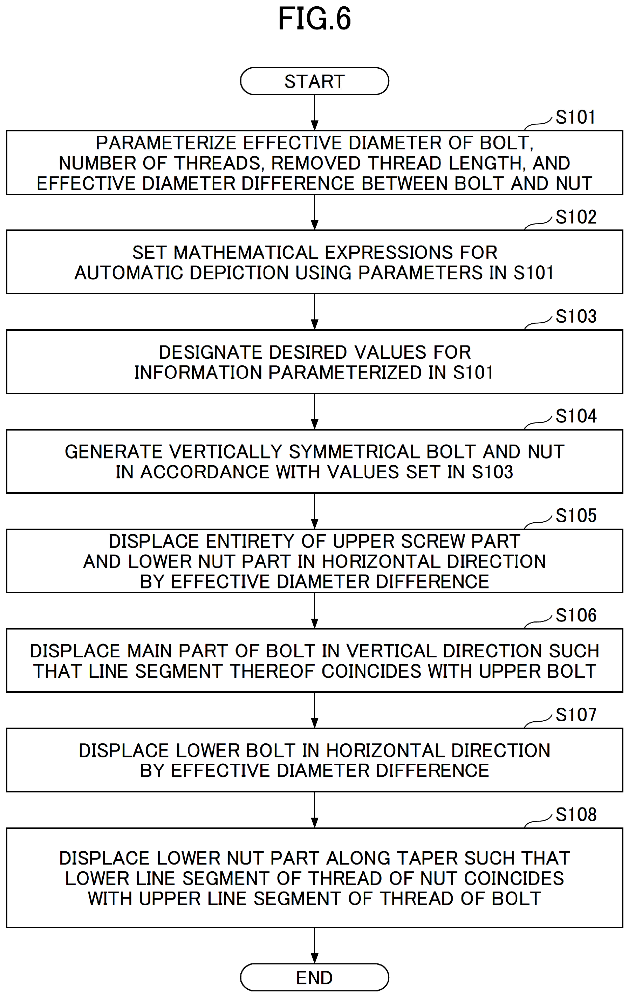

Next, a two-dimensional model generation method for generating a two-dimensional model (2DCAD data) of a cross-sectional view of a connected structure of the first column member 21, the first joint member 22, and the second column member 23, cut along the central axis of the electrode 20, will be described with reference to FIGS. 6 to 15. FIG. 6 is a flowchart for explaining the two-dimensional model generation method.

In step S101, the effective diameter of the bolt, the number of threads, the removed thread length, and the effective diameter difference between the bolt and the nut are parameterized. Here, the CPU 1 executes a program installed in the auxiliary memory device 4 or the like to cause the two-dimensional model generation device 10 to function as a CAD device. By executing the program installed in the auxiliary memory device 4 or the like, the CPU 1 parameterizes (or assigns a variable to) information to which a desired value will be designated in step S103 described later, among various types of information about the connected structure. In one example, as shown in FIG. 6, the "effective diameter of the bolt", the "number of threads", the "removed thread length", and the "effective diameter difference between the bolt and the nut" are parameterized.

Here, the "effective diameter of the bolt" is the effective diameter d₂ of the taper bolt shown in FIG. 5.

The one taper bolt (the first taper bolt) and the other taper bolt (the second taper bolt) have the same shape, and have the same number of taper bolt threads. In place of the "number of threads", the "length of the bolt" (l₁ shown in FIG. 5) may be parameterized. In this case, the number of threads may be calculated from the length of the bolt based on previously set information on the screw pitch and the like.

The "removed thread length" is the length from an end surface to the position at which screw cutting is started, and refers to the undercut length l₄ of the taper bolt and the undercut length l₅ of the taper nut shown in FIG. 5.

The "effective diameter difference between the bolt and the nut" is the difference (d₄-d₂) between the effective diameter d₂ of the taper bolt and the effective diameter d₄ of the taper nut shown in FIG. 5. In place of the "effective diameter difference between the bolt and the nut", the "effective diameter of the nut" may be parameterized. In this case, the "effective diameter difference between the bolt and the nut" may be calculated from the "effective diameter of the bolt" and the "effective diameter of the nut".

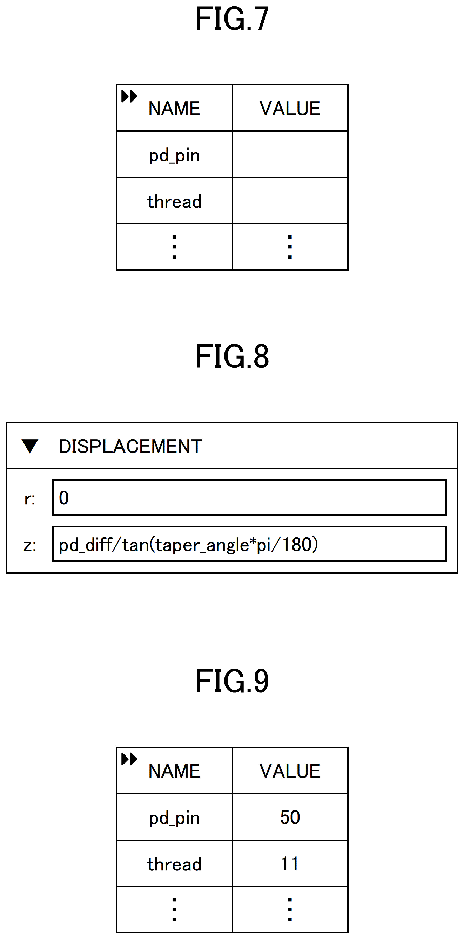

Further, the CPU 1 generates an interface to be displayed on the display device 5. FIG. 7 is an example of a parameter interface. In the example shown in FIG. 7, the CPU 1 generates an interface via which to input values for the effective diameter of the bolt (pd_pin), the number of threads (thread), and the like.

In step S102, mathematical expressions for automatic depiction using the parameters of step S101 are set. Here, the CPU 1 sets a mathematical expression for calculating values for any types of information that have not been parameterized in step S101 based on the parameters in step S101 among the information necessary for depicting the connected structure of the first column member 21, the first joint member 22, and the second column member 23.

FIG. 8 is an example of an interface displaying mathematical expressions that are set. The CPU 1 reads out, from the auxiliary memory device 4 or the like, and sets a mathematical expression for calculating a displacement z in step S106 described later, a mathematical expression for calculating a displacement r in step S108 described later, and the like.

In step S103, a desired value is designated for the information parameterized in step S101. Here, the CPU 1 causes the display device 5 to display an interface via which to enter inputs to the information parameterized in step S101 ("effective diameter of the bolt", "number of threads", "removed thread length", and "effective diameter difference between the bolt and the nut"), and receives inputs for the parameters. The operator inputs the values for the parameters by operating the operation device 6 or the like. FIG. 9 is an example of the parameter interface with values input.

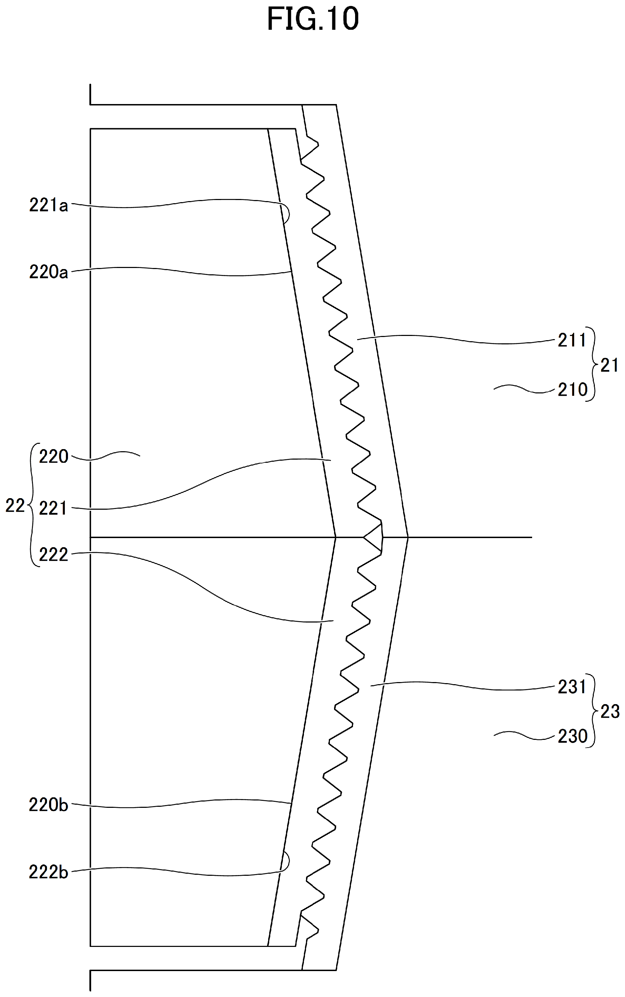

In step S104, vertically-symmetrical bolt and nut are generated in accordance with the values set in step S103. FIG. 10 is an example of the right half of a bisymmetrical two-dimensional axisymmetrical model generated in step S104.

The CPU 1 depicts the geometries (shapes) of the first column member 21, the first joint member (joint member) 22, and the second column member 23.

The first column member 21 has a first column member main part geometry 210 and a first taper nut part geometry 211. The first taper nut part geometry 211 is a geometry including the shape of the first taper nut. The first column member main part geometry 210 is the geometry of a part of the first column member 21 other than the first taper nut part geometry 211.

The first joint member 22 has a joint member main part geometry 220, a first taper bolt part geometry 221, and a second taper bolt part geometry 222. The first taper bolt part geometry 221 is a geometry including the shape of the first taper bolt. The first taper bolt part geometry 221 includes a taper line segment 221a parallel with the direction of the taper angle of the first taper bolt. The second taper bolt part geometry 222 is a geometry including the shape of the second taper bolt. The second taper bolt part geometry 222 includes a taper line segment 222b parallel with the direction of the taper angle of the second taper bolt. The joint member main part geometry 220 is a geometry of a part of the first joint member 22 other than the first taper bolt part geometry 221 and the second taper bolt part geometry 222. The joint member main part geometry 220 includes a taper line segment 220a coinciding with the taper line segment 221a and a taper line segment 220b coinciding with the taper line segment 222b.

The second column member 23 has a second column member main part geometry 230 and a second taper nut part geometry 231. The second taper nut part geometry 231 is a geometry including the shape of the second taper nut. The second column member main part geometry 230 is the geometry of a part of the second column member 23 other than the second taper nut part geometry 231.

Here, the CPU 1 depicts the joint member main part geometry 220, the first taper bolt part geometry 221, and the second taper bolt part geometry 222 based on the "effective diameter of the bolt", the "number of threads", and the "removed thread length" input in step S103.

Next, the CPU 1 depicts the first taper nut part geometry 211 such that the shape of the first taper bolt of the first taper bolt part geometry 221 and the shape of the first taper nut coincide with each other, and then further depicts the first column member main part geometry 210.

The CPU 1 depicts the second taper nut part geometry 231 such that the shape of the second taper bolt of the second taper bolt part geometry 222 and the shape of the second taper nut coincide with each other, and then further depicts the second column member main part geometry 230.

Here, the first taper bolt of the first taper bolt part geometry 221 and the second taper bolt of the second taper bolt part geometry 222 are depicted at positions of the effective diameter of the bolt. On the other hand, the first taper nut of the first taper nut part geometry 211 and the second taper nut of the second taper nut part geometry 231 are not depicted at positions of the effective diameter of the nut but are depicted at positions of the effective diameter of the bolt. The first taper bolt of the first taper bolt part geometry 221 and the first taper nut of the first taper nut part geometry 211 are in the state of contacting each other by both surfaces of each thread. Further, the second taper bolt of the second taper bolt part geometry 222 and the second taper nut of the second taper nut part geometry 231 are in the state of contacting each other by both surfaces of each thread.

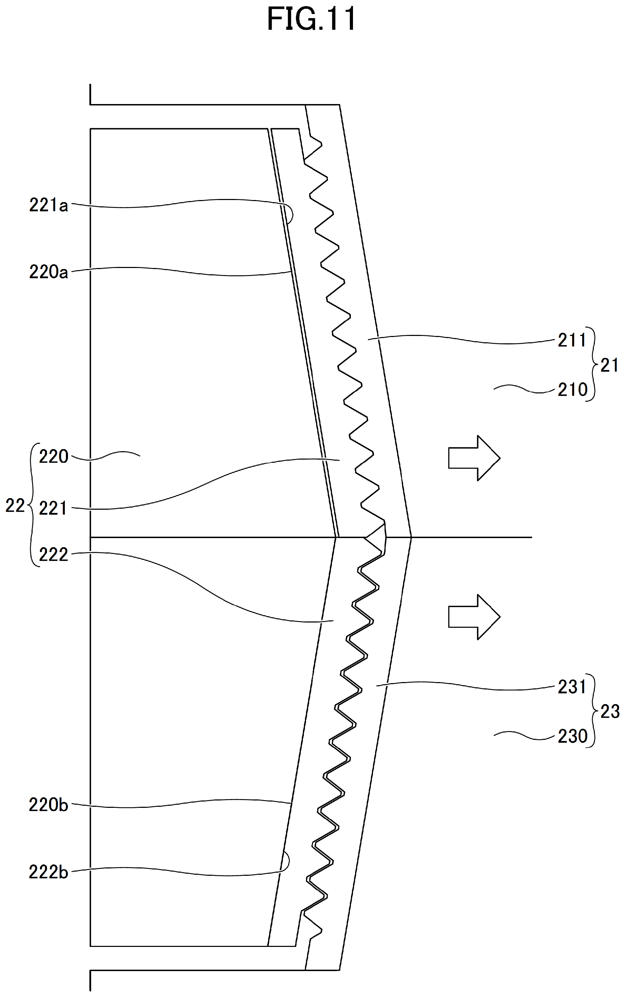

In step S105, the entirety of the upper screw part and the screw part of the lower nut are horizontally displaced by the effective diameter difference. FIG. 11 is an example of the two-dimensional model generated in step S105.

Here, the CPU 1 displaces the first taper nut part geometry 211, the first taper bolt part geometry 221, and the second taper nut part geometry 231 in a radially outward horizontal direction (see the outlined arrows) in the two-dimensional model by the effective diameter difference between the bolt and the nut. Thus, the first taper nut of the first taper nut part geometry 211 and the second taper nut of the second taper nut part geometry 231 are depicted at the positions of the effective diameter of the nut. Further, the first taper bolt of the first taper nut part geometry 211 and the first taper nut of the first taper nut part geometry 211 are in the state of contacting each other on both surfaces of each thread.

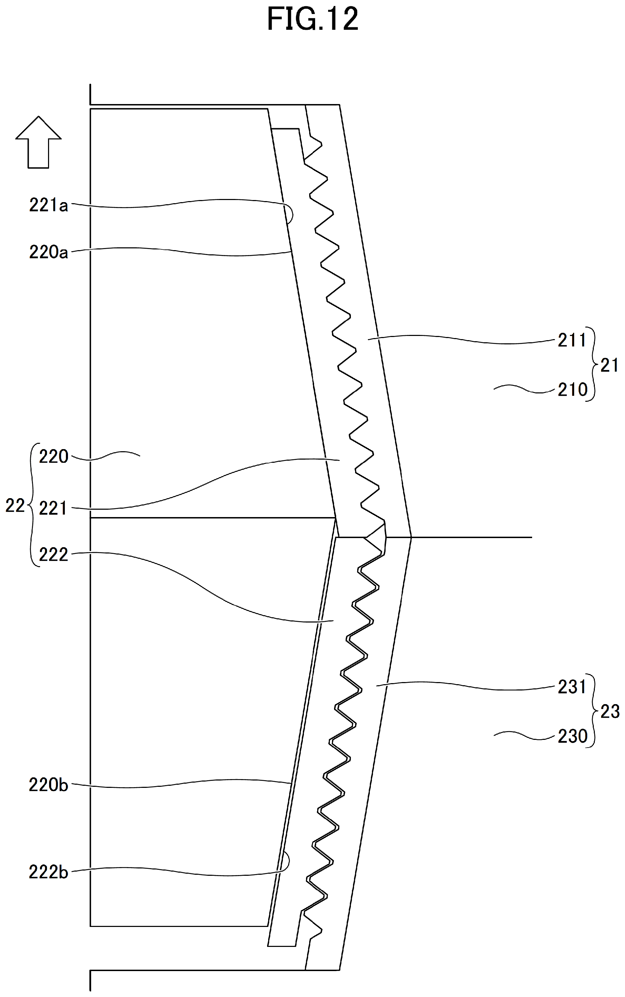

In step S106, the main part of the bolt is displaced in the vertical direction such that a line segment thereof coincides with the upper bolt. FIG. 12 is an example of the two-dimensional model generated in step S106.

Here, the CPU 1 displaces the joint member main part geometry 220 in the vertical direction (see the outlined arrow) in the two-dimensional model such that the taper line segment 220a (second taper line segment) of the joint member main part geometry 220 coincides with the taper line segment 221a (first taper line segment) of the first taper bolt part geometry 221. Specifically, the CPU 1 calculates the displacement z in the vertical direction based on the mathematical expression set in step S103 and the parameters input in step S104. The CPU 1 displaces the joint member main part geometry 220 in the vertical direction (see the outlined arrow) in the two-dimensional model such that the taper line segment 220a (second taper line segment) of the joint member main part geometry 220 coincides with the taper line segment 221a (first taper line segment) of the first taper bolt part geometry 221. The displacement z in the vertical direction is calculated as (d3-d2)/tanθ, where θ represents the taper angle, d2 represents the effective diameter of the bolt, and d3 represents the effective diameter of the nut.

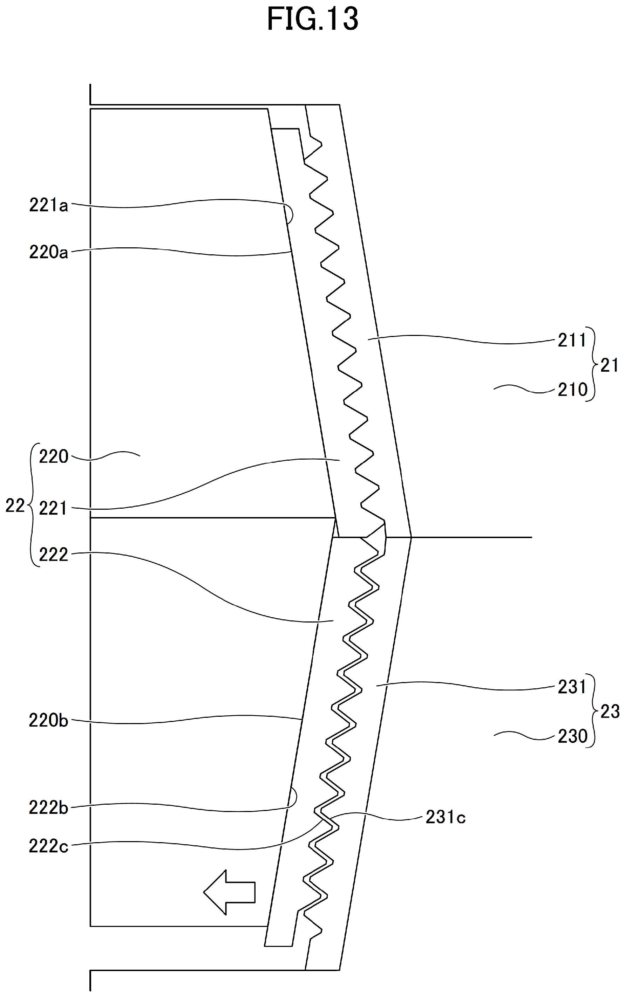

In step S107, the lower bolt part is horizontally displaced by the effective diameter difference. FIG. 13 is an example of the two-dimensional model generated in step S107.

Here, the CPU 1 displaces the second taper bolt part geometry 222 in a radially inward horizontal direction (see the outlined arrow, the direction opposite to the displacement direction in step S105) in the two-dimensional model by the effective diameter difference between the bolt and the nut (by the displacement in step S105). As a result, the taper line segment 222b (the third taper line segment) of the second taper bolt part geometry 222 coincides with the taper line segment 220b (the fourth taper line segment) of the joint member main part geometry 220.

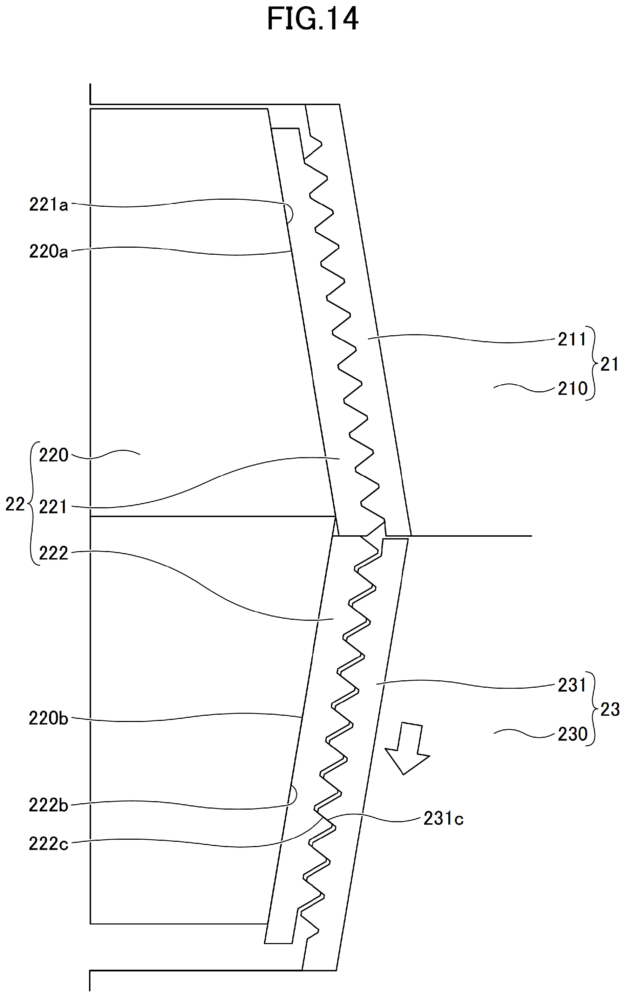

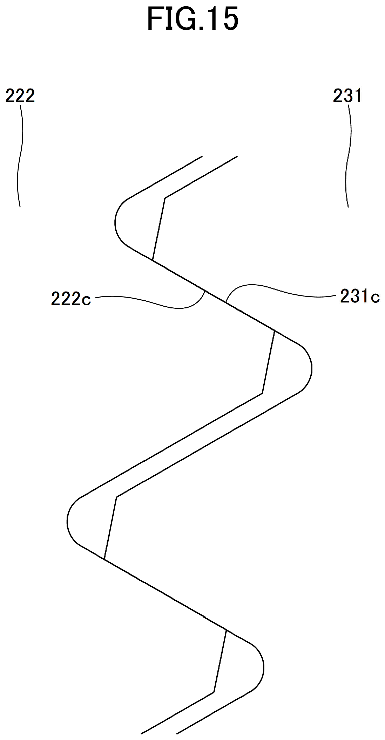

In step S108, the screw part of the lower nut of the lower screw part is displaced along the taper such that the lower line segment of a thread of the nut coincides with the upper line segment of a thread of the bolt. FIG. 14 is an example of the two-dimensional model generated in step S108. FIG. 15 is an example of a partially enlarged view of the second taper bolt part geometry 222 and the second taper nut part geometry 231 of the two-dimensional model generated in step S108.

Here, the CPU 1 displaces the second taper nut part geometry 231 in the direction along the taper (see the outlined arrow) in the two-dimensional model such that a lower line segment 231c of a thread of the second taper nut part geometry 231 coincides with an upper line segment 222c of a thread of the second taper bolt part geometry 222. Specifically, the CPU 1 calculates the displacement r in the direction along the taper based on the mathematical expression set in step S103 and the parameters input in step S104. The displacement r in the direction along the taper is calculated as (d3-d2)sinθ/2cos(30°-θ) in the horizontal direction and (d3-d2)cosθ·2cos(30°-θ) in the vertical direction, where 6 represents the taper angle, d2 represents the effective diameter of the bolt, and d3 represents the effective diameter of the nut. The CPU 1 displaces the second taper nut part geometry 231 in the direction along the taper (see the outlined arrow) in the two-dimensional model such that the lower line segment 231c of a thread of the second taper nut part geometry 231 coincides with the upper line segment 222c of a thread of the second taper bolt part geometry 222. Thus, the second taper bolt part geometry 222 and the second taper nut part geometry 231 enters a state of contacting each other by one side of the thread.

As described above, the CPU 1 can generate the geometry of the connected structure of the electrode 20. That is, the two-dimensional model generation device 10 can generate a two-dimensional model having the geometry of the connected structure of the electrode 20. This can reduce the working time of the operator.

As described above, in response to the operator inputting parameterized information ("effective diameter of the bolt", the "number of threads", the "removed thread length", and the "effective diameter difference between the bolt and the nut"), the two-dimensional model generation device 10 generates a two-dimensional model based on the input parameters. The generated two-dimensional model can be used for, for example, analytical simulation of the electrode 20 and the like.

Although the pieces of parameterized information have been described by taking the "effective diameter of the bolt", the "number of threads", the "removed thread length", and the "effective diameter difference between the bolt and the nut" for examples, they are not limited thereto. For example, the taper angle may be parameterized.

The aspects of the present disclosure are, for example, as follows.
[1] A two-dimensional model generation method for generating a two-dimensional model of a connected structure in which a first column member including a first taper nut part and a second column member including a second taper nut part are connected by a joint member including a main part, a first taper bolt part, and a second taper bolt part, the two-dimensional model generation method being performed by a computer, including:
   receiving parameters that are input;
   depicting the main part that is vertically symmetrical, the first taper bolt part and the second taper bolt part that are vertically symmetrical to each other, and the first taper nut part and the second taper nut part that are vertically symmetrical to each other based on the input parameters;
   displacing the first taper bolt part, the first taper nut part, and the second taper nut part in a radially outward horizontal direction based on the input parameters;
   displacing the main part of the joint member in a vertical direction based on the input parameters;
   displacing the second taper bolt part in a radially inward horizontal direction based on the input parameters; and
   displacing the second taper nut part along a taper based on the input parameters.
[2] The two-dimensional model generation method according to [1],
   wherein the input parameters include an effective diameter of a bolt, a number of threads, a removed thread length, and an effective diameter difference between a bolt and a nut.
[3] The two-dimensional model generation method according to [2],
   wherein in the displacing of the first taper bolt part, the first taper nut part, and the second taper nut part, the first taper bolt part, the first taper nut part, and the second taper nut part are displaced in the radially outward horizontal direction by the effective diameter difference between the bolt and the nut.
[4] The two-dimensional model generation method according to [3],
   wherein in the depicting, the first taper bolt part includes a first taper line segment, and the main part includes a second taper line segment coinciding with the first taper line segment, and
   wherein in the displacing of the main part of the joint member, the main part of the joint member is displaced in the vertical direction to a position at which the first taper line segment and the second taper line segment coincide with each other.
[5] The two-dimensional model generation method according to [4],
   wherein in the depicting, the second taper bolt part includes a third taper line segment, and the main part includes a fourth taper line segment coinciding with the third taper line segment, and
   wherein in the displacing of the second taper bolt part, the second taper bolt part is displaced in the radially inward horizontal direction to a position at which the third taper line segment and the fourth taper line segment coincide with each other.
[6] The two-dimensional model generation method according to [5],
   wherein in the displacing of the second taper nut part, the second taper nut part is displaced along the taper to a position at which a lower line segment of a thread of the second taper nut part coincides with an upper line segment of a thread of the second taper bolt part.
[7] A two-dimensional model generation device for generating a two-dimensional model of a connected structure in which a first column member including a first taper nut part and a second column member including a second taper nut part are connected by a joint member including a main part, a first taper bolt part, and a second taper bolt part, the two-dimensional model generation device including:
   an operation device; and
   a controller,
   wherein the controller is configured to perform:
      receiving parameters that are input via the operation device;
      depicting the main part that is vertically symmetrical, the first taper bolt part and the second taper bolt part that are vertically symmetrical to each other, and the first taper nut part and the second taper nut part that are vertically symmetrical to each other based on the input parameters;
      displacing the first taper bolt part, the first taper nut part, and the second taper nut part in a radially outward horizontal direction based on the input parameters;
      displacing the main part of the joint member in a vertical direction based on the input parameters;
      displacing the second taper bolt part in a radially inward horizontal direction based on the input parameters; and
      displacing the second taper nut part along a taper based on the input parameters.
[8] A program for causing a computer to generate a two-dimensional model of a connected structure in which a first column member including a first taper nut part and a second column member including a second taper nut part are connected by a joint member including a main part, a first taper bolt part, and a second taper bolt part,
   the program including causing the computer to perform:
   receiving parameters that are input;
   depicting the main part that is vertically symmetrical, the first taper bolt part and the second taper bolt part that are vertically symmetrical to each other, and the first taper nut part and the second taper nut part that are vertically symmetrical to each other based on the input parameters;
   displacing the first taper bolt part, the first taper nut part, and the second taper nut part in a radially outward horizontal direction based on the input parameters;
   displacing the main part of the joint member in a vertical direction based on the input parameters;
   displacing the second taper bolt part in a radially inward horizontal direction based on the input parameters; and
   displacing the second taper nut part along a taper based on the input parameters.

It should be noted that the present invention is not limited to the configurations presented here, such as the configurations set forth in the foregoing embodiments, combinations with other elements, and the like. These points can be modified within a range not departing from the spirit of the present invention, and can be appropriately defined in accordance with the modes of applications thereof.

The present application claims priority to Japanese Patent Application No. 2023-152322 filed on September 20, 2023, and the entire contents of the Japanese patent application are incorporated herein by reference.

### REFERENCE SIGNS LIST

1: CPU (controller)
6: operation device
10: two-dimensional model generation device
20: electrode
21: first column member
22: first joint member
23: second column member
24: second joint member
25: third column member
210: first column member main part geometry
211: first taper nut part geometry
220: joint member main part geometry
221: first taper bolt part geometry
222: second taper bolt part geometry
230: second column member main part geometry
231: second taper nut part geometry
221a: taper line segment (first taper line segment)
222b: taper line segment (third taper line segment)
220a: taper line segment (second taper line segment)
220b: taper line segment (fourth taper line segment)

## Claims

1. A two-dimensional model generation method for generating a two-dimensional model of a connected structure in which a first column member including a first taper nut part and a second column member including a second taper nut part are connected by a joint member including a main part, a first taper bolt part, and a second taper bolt part, the two-dimensional model generation method being performed by a computer, comprising:
receiving parameters that are input;
depicting the main part that is vertically symmetrical, the first taper bolt part and the second taper bolt part that are vertically symmetrical to each other, and the first taper nut part and the second taper nut part that are vertically symmetrical to each other based on the input parameters;
displacing the first taper bolt part, the first taper nut part, and the second taper nut part in a radially outward horizontal direction based on the input parameters;
displacing the main part of the joint member in a vertical direction based on the input parameters;
displacing the second taper bolt part in a radially inward horizontal direction based on the input parameters; and
displacing the second taper nut part along a taper based on the input parameters.

2. The two-dimensional model generation method according to claim 1,
wherein the input parameters include an effective diameter of a bolt, a number of threads, a removed thread length, and an effective diameter difference between a bolt and a nut.

3. The two-dimensional model generation method according to claim 2,
wherein in the displacing of the first taper bolt part, the first taper nut part, and the second taper nut part, the first taper bolt part, the first taper nut part, and the second taper nut part are displaced in the radially outward horizontal direction by the effective diameter difference between the bolt and the nut.

4. The two-dimensional model generation method according to claim 3,
wherein in the depicting, the first taper bolt part includes a first taper line segment, and the main part includes a second taper line segment coinciding with the first taper line segment, and
wherein in the displacing of the main part of the joint member, the main part of the joint member is displaced in the vertical direction to a position at which the first taper line segment and the second taper line segment coincide with each other.

5. The two-dimensional model generation method according to claim 4,
wherein in the depicting, the second taper bolt part includes a third taper line segment, and the main part includes a fourth taper line segment coinciding with the third taper line segment, and
wherein in the displacing of the second taper bolt part, the second taper bolt part is displaced in the radially inward horizontal direction to a position at which the third taper line segment and the fourth taper line segment coincide with each other.

6. The two-dimensional model generation method according to claim 5,
wherein in the displacing of the second taper nut part, the second taper nut part is displaced along the taper to a position at which a lower line segment of a thread of the second taper nut part coincides with an upper line segment of a thread of the second taper bolt part.

7. A two-dimensional model generation device for generating a two-dimensional model of a connected structure in which a first column member including a first taper nut part and a second column member including a second taper nut part are connected by a joint member including a main part, a first taper bolt part, and a second taper bolt part, the two-dimensional model generation device comprising:
an operation device; and
a controller,
wherein the controller is configured to perform:
receiving parameters that are input via the operation device;
depicting the main part that is vertically symmetrical, the first taper bolt part and the second taper bolt part that are vertically symmetrical to each other, and the first taper nut part and the second taper nut part that are vertically symmetrical to each other based on the input parameters;
displacing the first taper bolt part, the first taper nut part, and the second taper nut part in a radially outward horizontal direction based on the input parameters;
displacing the main part of the joint member in a vertical direction based on the input parameters;
displacing the second taper bolt part in a radially inward horizontal direction based on the input parameters; and
displacing the second taper nut part along a taper based on the input parameters.

8. A program configured for causing a computer to generate a two-dimensional model of a connected structure in which a first column member including a first taper nut part and a second column member including a second taper nut part are connected by a joint member including a main part, a first taper bolt part, and a second taper bolt part, the program comprising causing the computer to perform:
receiving parameters that are input;
depicting the main part that is vertically symmetrical, the first taper bolt part and the second taper bolt part that are vertically symmetrical to each other, and the first taper nut part and the second taper nut part that are vertically symmetrical to each other based on the input parameters;
displacing the first taper bolt part, the first taper nut part, and the second taper nut part in a radially outward horizontal direction based on the input parameters;
displacing the main part of the joint member in a vertical direction based on the input parameters;
displacing the second taper bolt part in a radially inward horizontal direction based on the input parameters; and
displacing the second taper nut part along a taper based on the input parameters.
